(19) Europäisches Patentamt
European Patent Office
Office européen des brevets

(11) **EP 3 243 254 B1**

(12) **EUROPÄISCHE PATENTSCHRIFT**

(45) Veröffentlichungstag und Bekanntmachung des Hinweises auf die Patenterteilung:
**01.09.2021  Patentblatt 2021/35**

(21) Anmeldenummer: **16710156.7**

(22) Anmeldetag: **15.03.2016**

(51) Int Cl.:
***H02J 7/00*** *(2006.01)*

(86) Internationale Anmeldenummer:
**PCT/EP2016/055574**

(87) Internationale Veröffentlichungsnummer:
**WO 2016/150770 (29.09.2016 Gazette 2016/39)**

(54) **VERFAHREN UND VORRICHTUNG ZUM LADEN ODER ENTLADEN EINES ENERGIESPEICHERS**

METHOD AND APPARATUS FOR CHARGING OR DISCHARGING AN ENERGY STORE

PROCÉDÉ ET DISPOSITIF POUR CHARGER OU DÉCHARGER UN ACCUMULATEUR D'ÉNERGIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.03.2015  DE 102015205171**

(43) Veröffentlichungstag der Anmeldung:
**15.11.2017  Patentblatt 2017/46**

(73) Patentinhaber: **Siemens Aktiengesellschaft 80333 München (DE)**

(72) Erfinder:
- **BAMBERGER, Joachim**
  **80999 München (DE)**
- **MAJEWSKI, Kurt**
  **81541 München (DE)**
- **WOLFRUM, Philipp**
  **81539 München (DE)**

(56) Entgegenhaltungen:
**WO-A1-2010/076608      WO-A1-2013/151728
DE-A1-102010 010 409    US-A1- 2014 239 905**

EP 3 243 254 B1

**Beschreibung**

Die Erfindung betrifft ein Verfahren und eine Vorrichtung zum Laden oder Entladen eines elektro-chemischen Energiespeichers, dessen Alterungsverhalten durch eine Beschreibung seiner Entladungstiefe (Depth of Discharge, DoD) modelliert ist. Ferner betrifft die Erfindung ein elektrisches System und ein Computerprogrammprodukt.

Zur Bestimmung des wirtschaftlichen Nutzens eines elektro-chemischen Energiespeichers in einem Energiesystem ist die betriebsabhängige Alterung des Energiespeichers zu berücksichtigen. Der sog. benutzungsabhängige Lebensdauerverlust einer Lithium-Ionen-Batterie kann durch die nachfolgende Formel

$$\Delta SOH_{cycle,rel} = f(DoD) \cdot f(T) \cdot f(I) \cdot \Delta Q \qquad (1)$$

modelliert werden. In dieser Formel ist f(DoD) ein von der Entladungstiefe abhängiger nicht-linearer Faktor, f(T) ein von der Temperatur, die die Batteriezellen haben, abhängiger nicht-linearer Faktor, f(I) ein vom Strom abhängiger nicht-linearer Faktor und $\Delta Q$ stellt den Ladungsdurchsatz durch die Batterie dar. Der sog. SOH (State of Health) stellt den Gesundheitszustand der Batterie dar und beschreibt, wie weit das Maß der Batteriealterung schon fortgeschritten ist. Eine Alterung des SOH führt zu einer kapazitiven und/oder resistiven Alterung der Batterie, durch welche die Performanz der Batterie verringert wird. Schließlich muss die Batterie irgendwann ersetzt werden.

Die oben genannten Faktoren sind über verschiedene Batteriechemien hinweg auf ähnliche Weise bestimmbar. In Formel (1) sind f(T) und $\Delta Q$ als bekannt anzusehen. Der temperaturabhängige nicht-lineare Faktor f(T) ist aus Untersuchungen verschiedener Batterietypen (d.h. Batteriechemien) aus der Vergangenheit bekannt. Der temperaturabhängige Faktor f(T) ist durch das Arrhenius-Gesetzt gegeben:

$$f(T) = exp \frac{-E_a}{RT}, \qquad (2)$$

darin sind $E_a$ und R bekannte Parameter und T ist die Temperatur in Kelvin.

Der Ladungsdurchsatz $\Delta Q$ ist eine durch den Batteriebetrieb gegebene Größe, welche messtechnisch bestimmbar ist.

Der stromabhängige Faktor f(I) kann aus Alterungsexperimenten bestimmt werden. Typisch ist ein kleiner Faktor für Entladeströme und kleine Ladeströme und ein großer Faktor für große Ladeströme.

Der Faktor f(DoD) wird ebenfalls aus Alterungsexperimenten bestimmt. Die Alterung ist unterschiedlich in Abhängigkeit von Hub des Ladungszustands (State of Charge, SOC). Je größer der SOC-Hub, d.h. die Entladungstiefe, ist, desto größer ist der Faktor f(DoD). Allgemein ist ein Faktor f(DoD) typisch, der monoton mit der Entladungstiefe steigt.

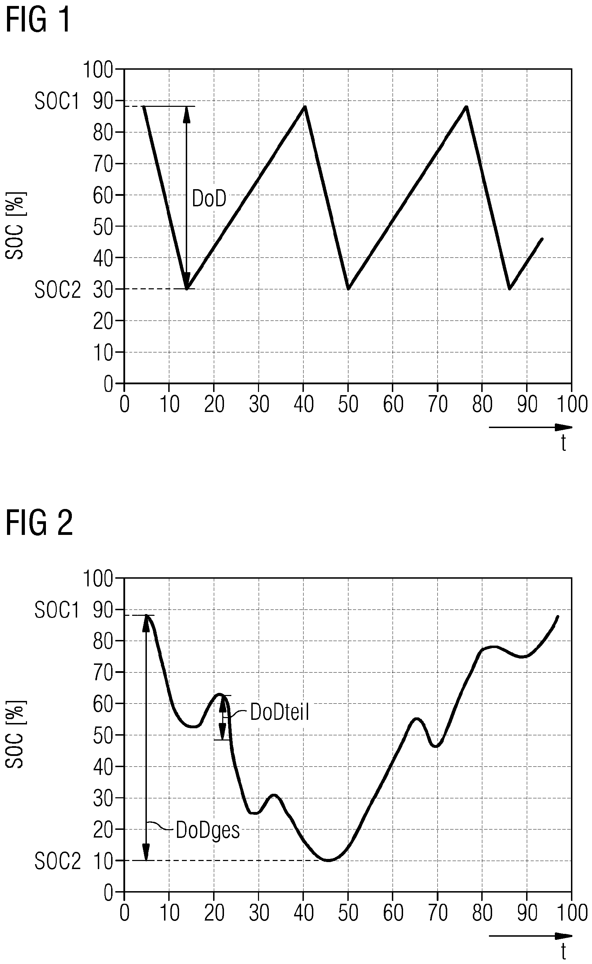

In den zur Bestimmung der Faktoren durchzuführenden Experimenten wird der Energiespeicher zyklisch mit gleichbleibendem SOC-Hub ge- und entladen, wie dies in Fig. 1 exemplarisch dargestellt ist. Fig. 1 zeigt den Verlauf des Ladungszustands SOC über der Zeit t. Der Ladungszustand SOC beträgt 100%, wenn der Energiespeicher voll geladen ist. Der Ladungszustand SOC beträgt 0%, wenn aus dem Energiespeicher keine Ladung mehr entnehmbar ist, der Energiespeicher somit leer ist. Die Zeit t ist im vorliegenden Ausführungsbeispiel normiert von 0 bis 100 aufgetragen. Der Verlauf des Ladungszustands ist in Fig. 1 derart, dass ausgehend von einem SOC1, der ungefähr 90% beträgt, der Ladungsspeicher bis zu einem SOC-Wert von etwa 30% mit gleichbleibendem Strom entladen wird. Anschließend erfolgt mit einem gleichbleibenden, jedoch anderen Strom ein Laden vom SOC2 zum SOC1. Anschließend wiederholt sich der Vorgang mehrmals. Die Differenz zwischen SOC2 und SOC1 stellt den SOC-Hub bzw. den DoD-Wert (DoD = SOC1-SOC2) dar, wie dies durch den Pfeil DoD in Fig. 1 dargestellt ist.

Ein Nachteil der Verwendung einer wie in Fig. 1 dargestellten zyklischen Entladung und Ladung des Energiespeichers besteht darin, dass sich aus diesen Experimenten nicht bestimmen lässt, was der Einfluss der genauen Form des SOC-Verlaufs auf die Alterung ist. Insbesondere lässt sich nicht bestimmen, ob die Beschreibung des DoD im Hinblick auf die betrachtete Batteriechemie korrekt ist.

Daher kommt alternativ zur Berechnung des DoD-Werts der sog. "Rainflow-Algorithmus" zur Anwendung. Hierbei wird ein wie in Fig. 2 gezeigter SOC-Verlauf als verschiedene, ineinander verschachtelte Teilzyklen unterschiedlichen Hubs interpretiert. Die Verwendung des Rainflow-Algorithmus ist für viele Batteriechemien eine gute Näherung. Für manche Batteriechemien ist der Rainflow-Algorithmus eine unzutreffende Methode zur Bestimmung des DoD und führt damit zu einer falschen Modellierung der Alterung. Hieraus ergeben sich somit falsch abgeleitete Ladestrategien.

Da der DoD gemäß Formel (1) einen Einfluss auf die Alterung eines Energiespeichers hat, ist die korrekte Beschreibung des DoD für eine korrekte Modellierung des Alterungsverhaltens erforderlich.

Die Druckschrift WO 2010/076608 A1 betrifft ein System und Verfahren zum Steuern der Lade- und Entladezyklen einer Batterie. Eine Ladesequenz CS wird mit mindestens einem Entladepuls DP unterbrochen und eine Entladesequenz DS wird mit mindestens einem Ladepuls CP unterbrochen. Die Entladepulse DP und die Ladepulse CP werden auch als Umkehrpulse ("reversing pulse") bezeichnet. Jede Lade- und Entladesequenz umfasst Lade- bzw. Entladezeiträume, welche sich mit den Entlade- bzw. Ladepulsen abwechseln. Die Entlade- bzw. Ladezeiträume werden auch als Vorwärtszeiträume ("forward period") bezeichnet. Die Intensität der Umkehrpulse CP, DP wird derart gewählt dass, die Abweichung des Hubs des Ladezustands ("variation of the state of charge") dSOC während eines Umkehrpulses CP, DP in dem Bereich von 0,01% und 1% des Gesamthubs ("total state of charge") SOC liegt.

Es ist Aufgabe der vorliegenden Erfindung, ein Verfahren und eine Vorrichtung anzugeben, mit welchen das Laden oder Entladen eines elektro-chemischen Energiespeichers, dessen Alterungsverhalten durch eine spezielle Beschreibung seiner Entladungstiefe modelliert ist, auf präzisere Weise ermöglicht ist. Eine weitere Aufgabe besteht darin, ein entsprechendes Computerprogrammprodukt anzugeben.

Die Aufgaben werden gelöst durch ein Verfahren gemäß den Merkmalen des Patentanspruchs 1, ein Computerprogrammprodukt gemäß den Merkmalen des Patentanspruchs 11, eine Vorrichtung gemäß den Merkmalen des Patentanspruchs 12 und ein elektrisches System gemäß den Merkmalen des Patentanspruchs 14. Vorteilhafte Ausgestaltungen ergeben sich aus den abhängigen Patentansprüchen.

Es wird ein Verfahren zum Laden oder Entladen eines elektro-chemischen Energiespeichers vorgeschlagen, dessen Alterungsverhalten durch eine Beschreibung seiner Entladungstiefe (Depth of Discharge) modelliert ist, bei der in einem zeitabhängigen Ladezustandsverlauf jedem Zeitraum zwischen zwei benachbarten lokalen Maxima und Minima ein Entladungstiefenwert zugeordnet ist, der dem Lade- oder Entladehub zwischen den Ladezustandswerten der beiden benachbarten lokalen Maxima und Minima entspricht.

Als lokales Maximum oder Minimum des zeitabhängigen Ladezustandsverlaufs werden auch Punkte gezählt, bei denen der Lade- oder Entladestrom kurzzeitig, d.h. für eine kurze Zeitspanne, den Wert 0 hat. Diese Art der Modellierung der Entladungstiefe (nachfolgend auch als DoD-Modellierung bezeichnet) bedeutet, dass ein großer Entladevorgang durch kurzes Anhalten oder ein kurzes Laden unterbrochen und in zwei kleine Teilzyklen unterteilt wird. Die Entladungstiefe (DoD) dieses Entladevorgangs verringert sich dadurch auf kleinere Werte, die durch den SOC-Hub vor bzw. nach der Unterbrechung gegeben sind. Gleiches gilt auch für einen Ladevorgang, welcher durch kurzes Anhalten oder kurzzeitiges Entladen unterbrochen und in zwei kleine Teilzyklen unterteilt wird.

Die beschriebene Modellierung eignet sich nicht für sämtliche Arten von Batteriechemien. Es wurde jedoch herausgefunden, dass ein derartiges DoD-Verhalten bei Lithium-Ionen-Akkumulatoren, insbesondere Lithium-Titanat-Akkumulatoren präzise ist.

Bei dem erfindungsgemäßen Verfahren wird der Energiespeicher von einem ersten Ladezustand zu einem ersten Zeitpunkt hin zu einem zweiten Ladezustand zu einem zweiten Zeitpunkt überführt, indem innerhalb des zwischen dem ersten und dem zweiten Zeitpunkt gebildeten Zeitraums der Lade- oder Entladevorgang zur Ausbildung von jeweiligen Lade- oder Entladeteilblöcken mit einem jeweiligen Lade- oder Entladehub zumindest einmal unterbrochen wird, wobei ein jeweiliger Lade- oder Entladehub kleiner als der Gesamthub zwischen dem ersten und dem zweiten Ladezustand ist.

Eine Anpassung der Höhe des Ladestroms oder Entladestroms wird für jeden Lade- oder Entladeteilblock in Abhängigkeit der Länge der vorangegangenen Unterbrechung erfolgen, so dass sichergestellt ist, dass zum zweiten Zeitpunkt der zweite Ladezustand erreicht.

Durch dieses Verfahren ergeben sich im Vergleich zu einem ununterbrochenen vollständigen Laden oder Entladen von dem ersten Ladezustand zu dem zweiten Ladezustand kürzere Lade- bzw. Entladeteilblöcke mit einem jeweiligen (kleineren) Ladehub. Durch dieses Verfahren kann die Batteriealterung gegenüber einem konstanten Laden ohne Unterbrechung von dem ersten Ladezustand zu dem zweiten Ladezustand deutlich verringert werden. Da eine Batteriealterung zu einer Abnahme der Kapazität und einer Erhöhung des Innenwiderstands führt, wird durch das vorgeschlagene Verfahren die Lebensdauer der Batterie erhöht. Gleichzeitig wird der Wirkungsgrad der Batterie aufgrund der im Vergleich geringeren Zunahme des Innenwiderstands verbessert.

Eine Unterbrechung zwischen zwei Lade- oder Entladeteilblöcken kann einen Lade- oder Entladestrom des Wertes 0 umfassen. Um somit einen Lade- oder Entladevorgang in wenigstens zwei Lade- bzw. Entladeteilblöcke zu unterteilen, ist es ausreichend, wenn der Lade- bzw. Entladevorgang für eine bestimmte Zeit unterbrochen wird. Die Unterbrechung bedeutet somit, dass der Lade- oder Entladestrom den Wert 0 umfasst.

Eine Unterbrechung zwischen zwei Ladeteilblöcken kann einen Entladeabschnitt umfassen. Alternativ kann eine Unterbrechung zwischen zwei Entladeteilblöcken einen Ladeabschnitt umfassen. Durch diese Ausgestaltungsvarianten werden Energiespeicher mit solchen Batteriechemien berücksichtigt, bei denen eine Unterbrechung, bei der der Lade- oder Entladestrom den Wert 0 aufweist, nicht ausreicht, um als Unterbrechung "erkannt" zu werden. Dadurch, dass ein Lade- oder Entladestrom mit einem umgekehrten Vorzeichen zu dem vorangegangenen Entlade- bzw. Ladevorgang durchgeführt wird, sind jedoch auch solche Energiespeicher in der Lage, die Unterbrechung in der erfindungsgemäßen Weise zu "erkennen".

Das Laden oder Entladen des Energiespeichers kann gemäß einer weiteren Ausgestaltung in regelmäßigen Abständen unterbrochen werden. Dies führt dazu, dass die Lade- bzw. Entladeteilblöcke eine gleiche Länge aufweisen.

Alternativ kann das Laden oder Entladen des Energiespeichers auch in unregelmäßigen Abständen unterbrochen werden.

Es kann weiterhin vorgesehen sein, dass die Zeitdauer der Unterbrechungen gleich lang sind. Die Zeitdauern der Unterbrechungen können alternativ auch unterschiedlich lang sein.

Das Laden oder Entladen des Energiespeichers kann gemäß einer weiteren Ausgestaltung in den Lade- oder Entladeteilblöcken zumindest abschnittsweise mit einem konstanten Strom erfolgen. Dies bedeutet, innerhalb eines Lade- oder Entladeteilblockes weist der Lade- oder Entladestrom den gleichen Betrag auf. Alternativ können innerhalb eines Lade- oder Entladeteilblöckes mehrere Abschnitte mit unterschiedlichen Lade- oder Entladeströmen vorgesehen sein. Es kann ebenso vorgesehen sein, dass der für einen Entladeteilblock zur Anwendung kommende Lade- oder Entladestrom auch in wenigstens einem anderen oder sogar allen anderen Lade- oder Entladeteilblöcken zur Anwendung gelangt. Welche der genannten Varianten am besten ist, hängt einerseits von dem Ausmaß des Ladehubs zwischen dem ersten und dem zweiten Ladezustand und andererseits von der Batteriechemie des betrachteten Energiespeichers ab.

Es wird ferner ein Computerprogrammprodukt vorgeschlagen, das direkt in den internen Speicher eines digitalen Rechners zum Steuern der Ladung und/oder Entladung des elektro-chemischen Energiespeichers geladen werden kann und Softwarecodeabschnitte umfasst, mit denen die Schritte des oben beschriebenen Verfahrens ausgeführt werden, wenn das Produkt auf dem Rechner läuft.

Gemäß einem weiteren Aspekt der Erfindung wird eine Vorrichtung zum Laden oder Entladen eines elektro-chemischen Energiespeichers vorgeschlagen, dessen Alterungsverhalten durch eine Beschreibung seiner Entladungstiefe modelliert ist, bei der in einem zeitabhängigen Ladezustandsverlauf jedem Zeitraum zwischen zwei benachbarten lokalen Maxima und Minima, ein Entladungstiefenwert zugeordnet ist, der dem Lade- oder Entladehub zwischen den Ladezustandswerten der beiden benachbarten lokalen Maxima und Minima entspricht. Die Vorrichtung ist dazu ausgebildet, den Energiespeicher von einem ersten Ladezustand zu einem ersten Zeitpunkt hin zu einem zweiten Ladezustand zu einem zweiten Zeitpunkt zu überführen, in dem innerhalb des zwischen dem ersten und dem zweiten Zeitpunkt gebildeten Zeitraums der Lade- oder Entladevorgang zur Ausbildung von jeweiligen Lade- oder Entladeteilblöcken mit einem jeweiligen Lade- oder Entladehub zumindest einmal unterbrochen wird, wobei ein jeweiliger Lade- oder Entladehub kleiner als der Gesamthub zwischen dem ersten und dem zweiten Ladezustand ist.

Eine Anpassung der Höhe des Ladestroms oder Entladestroms wird für jeden Lade- oder Entladeteilblock in Abhängigkeit der Länge der vorangegangenen Unterbrechung erfolgen, so dass sichergestellt ist, dass zum zweiten Zeitpunkt der zweite Ladezustand erreicht.

Die Vorrichtung kann weitere Mittel zur Durchführung des Verfahrens umfassen.

Die Vorrichtung weist die gleichen Vorteile auf, wie diese vorstehend in Verbindung mit dem erfindungsgemäßen Verfahren beschrieben wurden.

Schließlich schlägt die Erfindung ein elektrisches System vor, das eine Vorrichtung der oben genannten Art und einen Energiespeicher umfasst, wobei der Energiespeicher ein Lithium-Titanat-Akkumulator oder ein Energiespeicher mit einer vergleichbaren Batteriechemie ist. Bei dem Energiespeicher kann es sich beispielsweise um eine Traktionsbatterie eines elektrisch betriebenen Fahrzeugs oder eines Hybridfahrzeugs, welches neben einem elektrischen Antrieb über einen verbrennungsmotorischen Antrieb verfügt, handeln. Der Energiespeicher kann auch in einem autarken Energieversorgungsnetzwerk, z.B. zur Zwischenspeicherung von regenerativ erzeugter Energie, Anwendung finden. Ein solches Energieversorgungsnetzwerk kann auch eine Verbindung zu einem herkömmlichen Verbund-Energieversorgungsnetzwerk aufweisen.

Die Erfindung wird nachfolgend näher anhand von Ausführungsbeispielen in der Zeichnung näher beschrieben. Es zeigen:

Fig. 1 einen bereits beschriebenen zyklischen Lade- und Entladezustandsverlauf eines elektro-chemischen Energiespeichers,

Fig. 2 eine bereits beschriebene Ladekurve eines elektrochemischen Energiespeichers zur Anwendung des bekannten "Rainflow-Algorithmus" zur Ermittlung eines Entladungstiefenwerts,

Fig. 3 die aus Fig. 2 bekannte Ladekurve, anhand der eine erfindungsgemäß zur Anwendung kommende Beschreibung seiner Entladungstiefe erläutert wird,

Fig. 4 einen erfindungsgemäß vorgeschlagenen Ladezustandsverlauf beim Laden eines elektro-chemischen Energiespeichers, dessen Alterungsverhalten durch eine erfindungsgemäße Beschreibung seiner Entladungstiefe modellierbar ist, und

Fig. 5 einen erfindungsgemäß vorgeschlagenen Entladezustandsverlauf beim Entladen eines elektro-chemischen Energiespeichers, dessen Alterungsverhalten durch eine erfindungsgemäße Beschreibung seiner Entladungstiefe modellierbar ist.

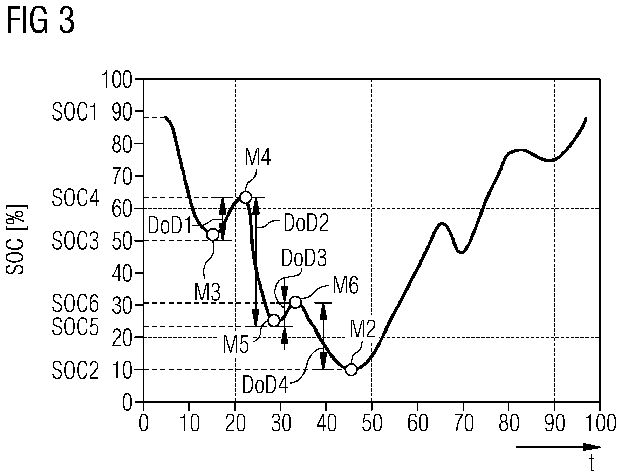

Fig. 3 zeigt einen exemplarischen zeitabhängigen Ladezustandsverlauf. Auf der x-Achse ist die normierte Zeit t von 0 bis 100 aufgetragen. Auf der y-Achse ist der Ladezustand (State of Charge, SOC) in Prozent von 0 bis 100 aufgetragen. Dabei entspricht ein SOC-Wert von 100% einem voll aufgeladenen Energiespeicher, und ein SOC-Wert von 0% einem vollständig entleerten Energiespeicher.

In dem in Fig. 3 gezeigten exemplarischen Ladezustandsverlauf startet die Kurve bei einem SOC-Wert SOC1 von etwa 90% und wird zunächst auf einen SOC-Wert SOC3 von etwa 50% entladen. Anschließend erfolgt ein Ladevorgang auf einen SOC-Wert SOC4 von in etwa 65%. Hieran schließt sich ein Entladevorgang auf einen SOC-Wert SOC5 von etwa 25% an, der bis auf einen SOC-Wert SOC6 von etwa 30% ansteigt, bis schließlich eine Entladung auf den SOC-Wert SOC2 von etwa 10% erfolgt. Anschließend erfolgt ein Ladevorgang bis auf den SOC-Wert SOC1, wobei der Ladevorgang von zwei temporären Entladevorgängen (in der Fig. nicht näher gekennzeichnet) unterbrochen ist.

Der zu diesem exemplarischen Ladezustandsverlauf gehörende DoD-Wert wird dadurch bestimmt, dass zunächst die lokalen Maxima und Minima und der Ladezustandskurve bestimmt werden. So sind bei der gezeigten Ladezustandskurve lokale Minima M3, M5 und M2 sowie lokale Maxima M4 und M6 herausgehoben gekennzeichnet. Die lokalen Minima M3, M5 und M2 sind den SOC-Werten SOC3, SOC5 und SOC2 zugeordnet. Die lokalen Maxima M4 und M6 sind den SOC-Werten SOC4 und SOC6 zugeordnet.

Es ist anzumerken, dass als lokale Maxima und Minima auch solche Punkte eine Ladezustandskurve betrachtet werden, bei denen der Ladestrom für eine vorab definierte Zeit den Wert 0 annimmt. In dem in Fig. 3 gezeigten Ladezustandsverlauf sind jedoch keine solchen "Plateaus", bei denen für eine bestimmte Zeit der Lade- bzw. Entladestrom den Wert 0 annimmt, gezeigt.

In einem nächsten Schritt wird für jeden Zeitraum zwischen zwei Umkehrpunkten, d.h. einem lokalen Maximum und dem benachbarten lokalen Minimum, ein DoD-Wert zugeordnet, der den Ladehub zwischen den, den lokalen Maxima und Minima zugeordneten, SOC-Werten entspricht. Die entsprechenden DoD-Werte zwischen zwei Umkehrpunkten sind exemplarisch durch Pfeile gekennzeichnet. So entspricht der zwischen dem lokalen Minimum M3 und dem lokalen Maximum M4 entsprechende Ladehub dem DoD-Wert DoD1, der sich aus dem Betrag der Differenz der SOC-Werte SOC4-SOC3 ergibt. In entsprechender Weise wurde ein Ladehub DoD2 zwischen dem lokalen Maximum M4 und dem lokalen Minimum M5 ermittelt, der sich aus dem Betrag der Differenz der SOC-Werte SOC4-SOC5 ergibt. Analog hierzu ergibt sich ein DoD-Wert DoD3 zwischen dem lokalen Minimum M5 und dem lokalen Maximum M6 aus dem Betrag der Differenz der SOC-Werte SOC6-SOC5. Schließlich wurde der DoD-Wert DoD4 zwischen dem lokalen Maximum M6 und dem lokalen Minimum M2 ermittelt, dessen Hub sich aus dem Betrag der Differenz der SOC-Werte SOC6-SOC2 ergibt. Der Einfachheit halber wurden die entsprechenden DoD-Werte für die weiteren, in der Ladekurve enthaltenen lokalen Maxima und Minima nicht eingezeichnet.

Da das beschriebene Vorgehen ein fortlaufendes Berechnungsverfahren ist, wurde der Einfachheit halber dem SOC-Wert SOC1 kein Anfangspunkt zugeordnet. Grundsätzlich ist dies jedoch auch möglich.

Diese Art der DoD-Modellierung bedeutet, dass der bloße Entladevorgang von dem Ladezustandswert SOC1 zu dem Ladezustandswert SOC2 ein- oder mehrmals durch ein Anhalten oder einen Lade- bzw. Entladevorgang in entgegengesetzter Richtung unterbrochen wird und in mehrere kleine Teilzyklen unterteilt wird. Der DoD des Entladevorgangs von dem Ladezustandswert SOC1 zu dem Ladezustandswert SOC2 verringert sich dadurch auf die kleineren Werte zwischen den benachbarten lokalen Maxima und Minima (Umkehrpunkten), die durch den Ladehub vor bzw. den nach der Unterbrechung gegeben sind.

Eine derartige Modellierung trifft insbesondere auf Lithium-Ionen-Akkumulatoren und hier insbesondere auf Lithium-Titanat-Akkumulatoren zu.

Ausgehend von der oben beschriebenen Modellierung ergeben sich die nachfolgend beschriebenen exemplarischen Lade- und Entladestrategien, welche die Lebensdauer der Batterie erhöhen und den Wirkungsgrad der Batterie über die Zeit verbessern, im Vergleich zu Lade- und Entladestrategien, denen beispielsweise eine Modellierung des DoD nach dem Rainflow-Algorithmus zugrunde liegt.

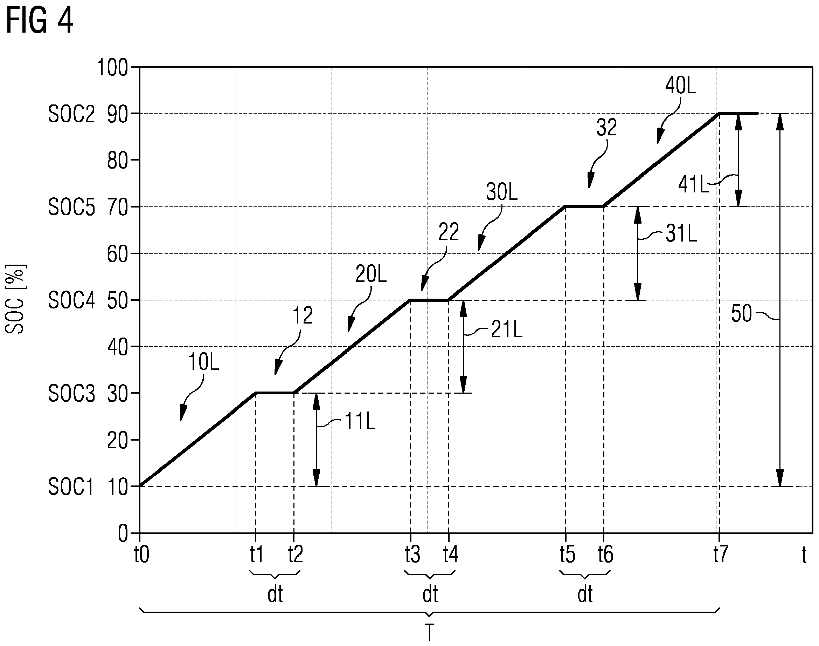

Fig. 4 zeigt eine Ladezustandskurve gemäß dem der Erfindung zugrundeliegenden Verfahren. Um den Energiespeicher zum Zeitpunkt t0 vom Ladezustand SOC1 zum Ladezustand SOC2 zum Zeitpunkt t7 zu überführen, erfolgt ein Laden mit einem konstanten Strom, wobei dieser Ladevorgang in regelmäßigen Abständen für einen jeweiligen, kurzen Zeitraum dt unterbrochen wird. Der Ladestrom ergibt sich durch

$$I = \frac{Cap*(SOC2-SOC1)}{100*(T-dt*n)} \qquad (3)$$

Dabei sind SOC1 der Ladezustand zum Zeitpunkt t0, SOC2 der Ladezustand zum Zeitpunkt t7, Cap die Kapazität des Energiespeichers in Amperstunden, T die Zeitdauer zwischen t7 und t1 (T = t7-t1), dt die Zeitdauer der Unterbrechung des Ladevorgangs und n die Anzahl der Unterbrechungen.

Durch dieses Ladeverfahren ergeben sich eine Anzahl an Ladeteilblöcken mit einem jeweiligen Ladehub

$$\frac{(SOC2-SOC1)}{n} \qquad (4)$$

In dem in Fig. 4 gezeigten Ausführungsbeispiel ist der SOC-Wert SOC1 = 10% zum Zeitpunkt t0. Zum Zeitpunkt t7 soll der SOC-Wert SOC2 = 90% erreicht werden. Beispielhaft umfasst der Ladevorgang vier Ladeteilblöcke 10L, 20L, 30L, 40L. Zwischen zwei aneinandergrenzenden Ladeteilblöcken 10L, 20L bzw. 20L, 30L bzw. 30L, 40L sind die bereits erwähnten Unterbrechungen 12, 22, 32 der Länge dt dargestellt, in denen der Ladestrom I = 0 ist. Der Ladehub DoD ist aufgrund des gleichen Ladestroms I in allen Ladeteilblöcken, 10L, 20L, 30L, 40L und der jeweiligen gleichen Ladedauern gleich groß. In Fig. 4 ist dieser durch die Bezugszeichen 11L für den Ladeteilblock 10L, 21L für den Ladeteilblock 20L, 31L für den Ladeteilblock 30L und 41L für den Ladeteilblock 40L gekennzeichnet. Im Gesamten ergibt sich ein Ladehub von SOC2-SOC1, wobei der gesamte Ladehub mit dem Bezugszeichen 50 gekennzeichnet ist.

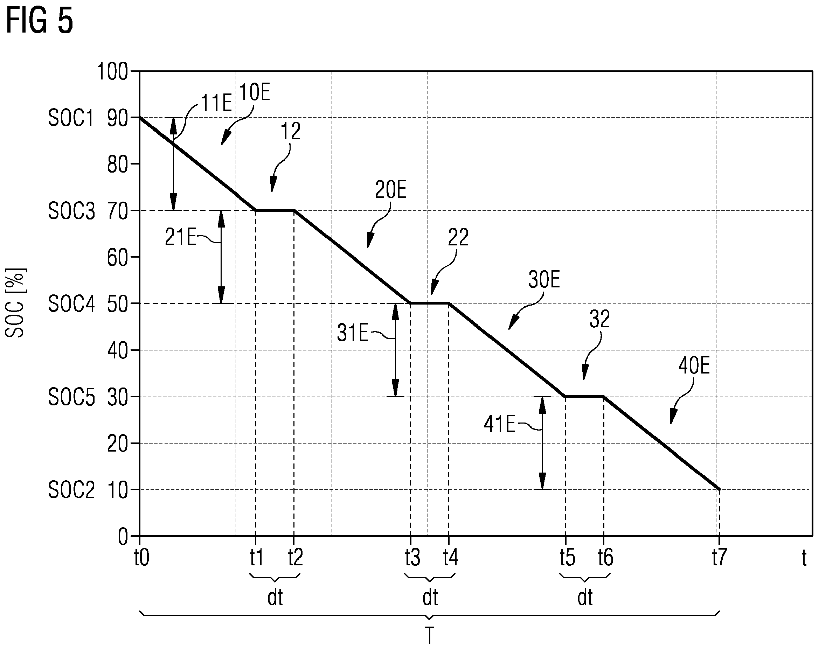

In entsprechender Weise zeigt Fig. 5 eine Entladezustandskurve gemäß der von einem SOC-Wert SOC1 = 90% zum Zeitpunkt t0 eine Entladung des SOC-Werts SOC2 zum Zeitpunkt t7 erreicht werden soll. In Analogie zum vorangegangenen Ausführungsbeispiel ist der Entladevorgang lediglich beispielhaft in vier gleich lange Entladeteilblöcke 10E, 20E, 30E, 40E unterteilt, wobei zwischen zwei Entladeteilblöcken 10E, 20E bzw. 20E, 30E bzw. 30E, 40E jeweilige Unterbrechungen 12, 22, 32 vorgesehen sind, in denen der Entladestrom I = 0 ist. Lediglich beispielhaft sind auch hier die Unterbrechungen 12, 22, 32 von gleicher Zeitdauer dt. Aufgrund des in jedem Entladeteilblock 10E, 20E, 30E, 40E gleichen Entladestroms (der sich aus der gleichen negativen Steigung der jeweiligen Abschnitte ergibt) und der jeweils gleich langen Unterbrechungen 12, 22, 32 ergibt sich für jeden Entladeteilblock 10E, 20E, 30E, 40E ein gleich großer Entladehub 11E, 21E, 31E, 41E.

Grundsätzlich sollten bei einem Ladevorgang die Ladepausen bzw. Unterbrechungen 12, 22, 32 möglichst kurz sein, um den benötigten Ladestrom, um innerhalb der Zeitdauer T von dem ersten Ladezustand SOC1 zu dem zweiten Ladezustand SOC2 zu gelangen, niedrig zu halten. Je länger die Unterbrechungen 12, 22, 32 gewählt sind, desto größer wird der in den Ladeteilblöcken benötigte Ladestrom, d.h. desto steiler verlaufen die Abschnitte der Ladeteilblöcke 10L, 20L, 30L, 40L. Damit kann auch eine einhergehende Schädigung des Energiespeichers beim Laden vermieden werden.

Grundsätzlich ergibt sich die Höhe des Ladestroms in Abhängigkeit der Randbedingung, dass innerhalb der Zeitdauer T der zu erzielende Ladezustand SOC2 erreicht werden muss. Eine weitere Randbedingung ist die Batteriechemie des Energiespeichers, welche einen maximalen Ladestrom zulässt, ohne dabei negativ beeinflusst zu werden.

Demgegenüber sind bei einem Entladevorgang auch längere Unterbrechungen und dementsprechend höhere Entladeströme akzeptabel.

Obwohl in den Ausführungsbeispielen gemäß den Fig. 4 und 5 gleich lange Lade- bzw. Entladeteilblöcke 10L, ..., 40L bzw. 10E, ..., 40E dargestellt sind, können die Lade- bzw. Entladeteilblöcke eine individuell unterschiedliche Länge mit einem individuell unterschiedlichen Lade- bzw. Entladestrom aufweisen. Ebenso kann die Länge dt der Unterbrechungen 12, 22, 32 zwischen jeweiligen Lade- bzw. Entladeteilblöcken unterschiedlich lang gewählt werden. Es ist ferner ebenfalls möglich, dass bei einem Ladevorgang oder einem Entladevorgang die Lade- bzw. Entladeströme individuell für jeden Lade- bzw. Entladeteilblock gewählt werden. Sogar innerhalb eines Lade- bzw. Entladeteilblocks können die Lade- bzw. Entladeströme variiert werden. Die Variation erfolgt unter der Randbedingung, dass innerhalb der Zeitdauer T ein Laden bzw. Entladen von dem ersten Ladezustand SOC1 auf den zweiten Ladezustand SOC2 möglich ist.

Bei regelmäßigen Unterbrechungen sollte das Unterbrechungsintervall dt, d.h. die Zeitdauer zwischen t3 und t1 bzw. t5 und t3 bzw. t7 und t5 derart gewählt werden, dass der sich ergebende DoD-Wert die Alterung gegenüber einen ununterbrochenen Ladevorgang ausreichend verringert. Andererseits sollte das Intervall dt nicht so klein gewählt werden, dass der Ladestrom dadurch bei fester Zeitdauer dt der Unterbrechungen 12, 22, 32 unnötig hoch wird bzw. innerhalb von vorgegebenen Grenzen bleibt.

Durch die vorgeschlagene Ladestrategie verändert sich die Batteriealterung in erster Näherung um den Faktor

$$\frac{f_{DoD}\left((SOC2-SOC1)\frac{1}{n}\right)}{f_{DoD}(SOC2-SOC1)} \qquad (5)$$

Dieser Faktor ist typischerweise kleiner als 1, was bedeutet, dass der Energiespeicher weniger altert, da die DoD-abhängige Alterung für kleine DoD-Werte typischerweise geringer ist als für große DoD-Werte. Falls in einer Anwendung eine gewünschte Reduktion der Alterung vorgegeben ist oder diese sich durch eine Optimierungsrechnung ergibt, kann das Unterbrechungsintervall über diesen Faktor berechnet werden, ggf. unter Berücksichtigung einer vorgegebenen Grenze des Lade- oder Entladestroms.

Falls durch Eigenheiten der Batteriechemie des Energiespeichers ein kurzer Gegenladevorgang notwendig ist, um einen Teillade- bzw. -entladeblock zu beenden, kann die Unterbrechung auch durch einen solchen Ladevorgang ersetzt werden. Unter einem Gegenladevorgang wird beispielsweise ein kurzer Ladevorgang verstanden, wenn ein Entladevorgang durchgeführt wird. Bei einem Ladevorgang wird in der Unterbrechung ein kurzer Entladevorgang durchgeführt. Die Stärke des Stroms beim Gegenladen muss so angepasst werden, dass der Hub SOC2 - SOC1 nach der Zeitdauer T immer noch erreicht wird.

## Patentansprüche

1. Verfahren zum Laden oder Entladen eines elektro-chemischen Energiespeichers, dessen Alterungsverhalten durch eine Beschreibung seiner Entladungstiefe (DoD) modelliert ist, bei der in einem zeitabhängigen Ladezustandsverlauf jedem Zeitraum zwischen zwei benachbarten lokalen Maxima und Minima ein Entladungstiefenwert zugeordnet ist, der dem Lade- oder Entladehub zwischen den Ladezustandswerten der beiden benachbarten lokalen Maxima und Minima entspricht, bei dem der Energiespeicher von einem ersten Ladezustand (SOC1) zu einem ersten Zeitpunkt (t0) hin zu einem zweiten Ladezustand (SOC2) zu einem zweiten Zeitpunkt (t7) überführt wird, indem innerhalb des zwischen dem ersten und dem zweiten Zeitpunkt (t0, t7) gebildeten Zeitraums (T) der Lade- oder Entladevorgang zur Ausbildung von jeweiligen Lade- oder Entladeteilblöcken (10L, 20L, 30L, 40L; 10E, 20E, 30E, 40E) mit einem jeweiligen Lade- oder Entladehub (11L, 21L, 31L, 41L; 11E, 21E, 31E, 41E) zumindest einmal unterbrochen wird, wobei ein jeweiliger Lade- oder Entladehub (11L, 21L, 31L, 41L; 11E, 21E, 31E, 41E) kleiner als der Gesamthub (50) zwischen dem ersten und dem zweiten Ladezustand (SOC1, SOC2) ist;

   **dadurch gekennzeichnet, dass**
   eine Anpassung der Höhe des Ladestroms oder Entladestroms für jeden Lade- oder Entladeteilblock (10L, 20L, 30L, 40L; 10E, 20E, 30E, 40E) in Abhängigkeit der Länge der vorangegangenen Unterbrechung (12, 22, 32) erfolgt, so dass
   sichergestellt ist, dass zum zweiten Zeitpunkt (t7) der zweite Ladezustand (SOC2) erreicht wird.

2. Verfahren nach Anspruch 1, bei dem eine Unterbrechung (12, 22, 32) zwischen zwei Lade- oder Entladeteilblöcken (10L, 20L, 30L, 40L; 10E, 20E, 30E, 40E) einen Lade- oder Entladestrom des Werts 0 umfasst.

3. Verfahren nach Anspruch 1 oder 2, bei dem eine Unterbrechung (12, 22, 32) zwischen zwei Ladeteilblöcken (10L, 20L, 30L, 40L; 10E, 20E, 30E, 40E) einen Entladeabschnitt umfasst.

4. Verfahren nach Anspruch 1 oder 2, bei dem eine Unterbrechung (12, 22, 32) zwischen zwei Entladeteilblöcken (10L, 20L, 30L, 40L; 10E, 20E, 30E, 40E) einen Ladeabschnitt umfasst.

5. Verfahren nach einem der Ansprüche 1 bis 4, bei dem das Laden oder Entladen des Energiespeichers in regelmäßigen Abständen unterbrochen wird.

6. Verfahren nach einem der Ansprüche 1 bis 4, bei dem das Laden oder Entladen des Energiespeichers in unregelmäßigen Abständen unterbrochen wird.

7. Verfahren nach einem der Ansprüche 1 bis 6, bei dem die Zeitdauern der Unterbrechungen (12, 22, 32) gleich sind.

8. Verfahren nach einem der Ansprüche 1 bis 6, bei dem die Zeitdauern der Unterbrechungen (12, 22, 32) unterschiedlich sind.

9. Verfahren nach einem der vorhergehenden Ansprüche, bei dem das Laden oder Entladen des Energiespeichers in den Lade- oder Entladeteilblöcken zumindest abschnittsweise mit einem konstanten Strom erfolgt.

10. Computerprogrammprodukt, das direkt in den internen Speicher eines digitalen Rechners zum Steuern der Ladung und/oder Entladung eines elektro-chemischen Energiespeichers geladen werden kann und Softwarecodeabschnitte umfasst, mit denen die Schritte gemäß einem der vorhergehenden Ansprüche, ausgeführt werden, wenn das Produkt auf dem Rechner läuft.

**11.** Vorrichtung zum Laden oder Entladen eines elektro-chemischen Energiespeichers, dessen Alterungsverhalten durch eine Beschreibung seiner Entladungstiefe (DoD) modelliert ist, bei der in einem zeitabhängigen Ladezustandsverlauf jedem Zeitraum zwischen zwei benachbarten lokalen Maxima und Minima ein Entladungstiefenwert zugeordnet ist, der dem Lade- oder Entladehub zwischen den Ladezustandswerten der beiden benachbarten lokalen Maxima und Minima entspricht, wobei die Vorrichtung dazu ausgebildet ist,

den Energiespeicher von einem ersten Ladezustand (SOC1) zu einem ersten Zeitpunkt (t0) hin zu einem zweiten Ladezustand (SOC2) zu einem zweiten Zeitpunkt (t7) zu überführen, indem innerhalb des zwischen dem ersten und dem zweiten Zeitpunkt (t0, t7) gebildeten Zeitraums (T) der Lade- oder Entladevorgang zur Ausbildung von jeweiligen Lade- oder Entladeteilblöcken (10L, 20L, 30L, 40L; 10E, 20E, 30E, 40E) mit einem jeweiligen Lade- oder Entladehub (10L, 20L, 30L, 40L; 10E, 20E, 30E, 40E) zumindest einmal unterbrochen wird, wobei ein jeweiliger Lade- oder Entladehub (10L, 20L, 30L, 40L; 10E, 20E, 30E, 40E) kleiner als der Gesamthub (50) zwischen dem ersten und dem zweiten Ladezustand (SOC1, SOC2) ist; **dadurch gekennzeichnet, dass** eine Anpassung der Höhe des Ladestroms oder Entladestroms für jeden Lade- oder Entladeteilblock (10L, 20L, 30L, 40L; 10E, 20E, 30E, 40E) in Abhängigkeit der Länge der vorangegangenen Unterbrechung (12, 22, 32) erfolgt, so dass sichergestellt ist, dass zum zweiten Zeitpunkt (t7) der zweite Ladezustand (SOC2) erreicht wird.

**12.** Elektrisches System, umfassend eine Vorrichtung gemäß einem der Ansprüche 11 und einem Energiespeicher, wobei der Energiespeicher ein Lithium-Titanat-Akkumulator oder ein Energiespeicher mit einer vergleichbaren Batteriechemie ist.

**Claims**

**1.** Method for charging or discharging an electrochemical energy store, the ageing behaviour of which is modelled by describing its depth of discharge (DoD), at which a depth-of-discharge value is associated with each time period between two adjacent local maxima and minima in a time-dependent state-of-charge profile, which depth-of-discharge value corresponds to the charging or discharging stroke between the state-of-charge values of the two adjacent local maxima and minima, in which the energy store is transitioned from a first state of charge (SOC1) at a first time (t0) to a second state of charge (SOC2) at a second time (t7) by way of the charging or discharging process being interrupted at least once within the time period (T) formed between the first and the second time (t0, t7) to form respective charging or discharging subblocks (10L, 20L, 30L, 40L; 10E, 20E, 30E, 40E) with a respective charging or discharging stroke (11L, 21L, 31L, 41L; 11E, 21E, 31E, 41E), wherein a respective charging or discharging stroke (11L, 21L, 31L, 41L; 11E, 21E, 31E, 41E) is smaller than the total stroke (50) between the first and the second state of charge (SOC1, SOC2);
**characterized in that**
the magnitude of the charging current or discharging current for each charging or discharging subblock (10L, 20L, 30L, 40L; 10E, 20E, 30E, 40E) is adapted in dependence on the length of the previous interruption (12, 22, 32), with the result that it is ensured that the second state of charge (SOC2) is reached at the second time (t7).

**2.** Method according to Claim 1, in which an interruption (12, 22, 32) between two charging or discharging subblocks (10L, 20L, 30L, 40L; 10E, 20E, 30E, 40E) comprises a charging or discharging current having the value 0.

**3.** Method according to Claim 1 or 2, in which an interruption (12, 22, 32) between two charging subblocks (10L, 20L, 30L, 40L; 10E, 20E, 30E, 40E) comprises a discharging section.

**4.** Method according to Claim 1 or 2, in which an interruption (12, 22, 32) between two discharging subblocks (10L, 20L, 30L, 40L; 10E, 20E, 30E, 40E) comprises a charging section.

**5.** Method according to one of Claims 1 to 4, in which the charging or discharging of the energy store is interrupted at regular intervals.

**6.** Method according to one of Claims 1 to 4, in which the charging or discharging of the energy store is interrupted at irregular intervals.

**7.** Method according to one of Claims 1 to 6, in which the time periods of the interruptions (12, 22, 32) are the same.

**8.** Method according to one of Claims 1 to 6, in which the time periods of the interruptions (12, 22, 32) differ.

**9.** Method according to one of the preceding claims, in which the charging or discharging of the energy store in the charging or discharging subblocks is effected at least in sections with a constant current.

**10.** Computer program product, which can be loaded directly into the internal memory of a digital computer for controlling the charging and/or discharging of an electrochemical energy store and which comprises software code sections with which the steps according to one of the preceding claims are carried out when the product runs on the computer.

**11.** Apparatus for charging or discharging an electrochemical energy store, the ageing behaviour of which is modelled by describing its depth of discharge (DoD), at which a depth-of-discharge value is associated with each time period between two adjacent local maxima and minima in a time-dependent state-of-charge profile, which depth-of-discharge value corresponds to the charging or discharging stroke between the state-of-charge values of the two adjacent local maxima and minima, wherein the apparatus is configured
for transitioning the energy store from a first state of charge (SOC1) at a first time (t0) to a second state of charge (SOC2) at a second time (t7) by way of the charging or discharging process being interrupted at least once within the time period (T) formed between the first and the second time (t0, t7) to form respective charging or discharging subblocks (10L, 20L, 30L, 40L; 10E, 20E, 30E, 40E) with a respective charging or discharging stroke (10L, 20L, 30L, 40L; 10E, 20E, 30E, 40E), wherein a respective charging or discharging stroke (10L, 20L, 30L, 40L; 10E, 20E, 30E, 40E) is smaller than the total stroke (50) between the first and the second state of charge (SOC1, SOC2);
**characterized in that**
the magnitude of the charging current or discharging current for each charging or discharging subblock (10L, 20L, 30L, 40L; 10E, 20E, 30E, 40E) is adapted in dependence on the length of the previous interruption (12, 22, 32), with the result that it is ensured that the second state of charge (SOC2) is reached at the second time (t7).

**12.** Electrical system, comprising an apparatus according to Claim 11 and an energy store, wherein the energy store is a lithium-titanate battery or an energy store having a comparable battery chemistry.


**Revendications**

**1.** Procédé de charge ou de décharge d'un accumulateur d'énergie électrochimique, dont le comportement de vieillissement est modélisé par une description de sa profondeur de décharge (DoD), dans lequel, dans un tracé de l'état de charge en fonction du temps, à chaque période entre deux maxima et minima locaux adjacents, correspond une valeur de profondeur de décharge qui correspond à la course de charge ou de décharge entre les valeurs d'état de charge des deux maxima ou minima locaux adjacents, dans lequel l'accumulateur d'énergie passe d'un premier état de charge (SOC1) à un premier instant (t0) à un deuxième état de charge (SOC2) à un deuxième instant (t7), en interrompant au moins une fois dans la période (T) formée entre les premier et deuxième instants (t0, t7), le processus de charge ou de décharge afin de former des blocs partiels respectifs de charge ou de décharge (10L, 20L, 30L, 40L ; 10E, 20E, 30E, 40E) avec une course de charge ou de décharge respective (11L, 21L, 31L, 41L ; 11E, 21E, 31E, 41E), dans lequel une course de charge ou de décharge respective (11L, 21L, 31L, 41L ; 11E, 21E, 31E, 41E) est inférieure à la course totale (50) entre les premier et deuxième états de charge (SOC1, SOC2) ;

**caractérisé en ce que**
une adaptation de la valeur du courant de charge ou du courant de décharge a lieu pour chaque bloc partiel de charge ou de décharge (10L, 20L, 30L, 40L ; 10E, 20E, 30E, 40E) en fonction de la longueur de l'interruption précédente (12, 22 32), de façon à garantir que, au deuxième instant (t7), le deuxième état de charge (SOC2) soit atteint.

**2.** Procédé selon la revendication 1, dans lequel une interruption (12, 22, 32) entre deux blocs partiels de charge ou de décharge (10L, 20L, 30L, 40L ; 10E, 20E, 30E, 40E) comprend un courant de charge ou de décharge de valeur 0.

**3.** Procédé selon la revendication 1 ou 2, dans lequel une interruption (12, 22, 32) entre deux blocs partiels de charge (10L, 20L, 30L, 40L ; 10E, 20E, 30E, 40E) comprend une portion de décharge.

**4.** Procédé selon la revendication 1 ou 2, dans lequel une interruption (12, 22, 32) entre deux blocs partiels de décharge (10L, 20L, 30L, 40L ; 10E, 20E, 30E, 40E) comprend une portion de charge.

**5.** Procédé selon l'une des revendications 1 à 4, dans lequel la charge ou la décharge de l'accumulateur d'énergie est interrompue à des intervalles réguliers.

6. Procédé selon l'une des revendications 1 à 4, dans lequel la charge ou la décharge de l'accumulateur d'énergie est interrompue à des intervalles irréguliers.

7. Procédé selon l'une des revendications 1 à 6, dans lequel les durées des interruptions (12, 22, 32) sont identiques.

8. Procédé selon l'une des revendications 1 à 6, dans lequel les durées des interruptions (12, 22, 32) sont différentes.

9. Procédé selon l'une des revendications précédentes, dans lequel la charge ou la décharge de l'accumulateur d'énergie dans les blocs partiels de charge ou de décharge a lieu, au moins à certains endroits, avec un courant constant.

10. Produit de programme informatique qui peut être chargé directement dans la mémoire interne d'un ordinateur pour le contrôle de la charge et/ou de la décharge d'un accumulateur d'énergie électrochimique et qui comprend des portions de codes de logiciel, avec lesquelles les étapes selon l'une des revendications précédentes sont exécutées lorsque le produit tourne sur l'ordinateur.

11. Dispositif de charge ou de décharge d'un accumulateur d'énergie électrochimique, dont le comportement de vieillissement est modélisé par une description de sa profondeur de décharge (DoD), dans lequel, dans un tracé de l'état de charge en fonction du temps, à chaque période entre deux maxima et minima locaux adjacents, correspond une valeur de profondeur de décharge qui correspond à la course de charge ou de décharge entre les valeurs d'état de charge des deux maxima ou minima locaux adjacents, dans lequel le dispositif est conçu pour faire passer l'accumulateur d'énergie d'un premier état de charge (SOC1) à un premier instant (t0) à un deuxième état de charge (SOC2) à un deuxième instant (t7), en interrompant, au moins une fois dans la période (T), formée entre les premier et deuxième instants (t0, t7), le processus de charge ou de décharge afin de former des blocs partiels respectifs de charge ou de décharge (10L, 20L, 30L, 40L ; 10E, 20E, 30E, 40E) avec une course de charge ou de décharge respective (11L, 21L, 31L, 41L ; 11E, 21E, 31E, 41E), dans lequel une course de charge ou de décharge respective (11L, 21L, 31L, 41L ; 11E, 21E, 31E, 41E) est inférieure à la course totale (50) entre les premier et deuxième états de charge (SOC1, SOC2) ;

   **caractérisé en ce que**
   une adaptation de la valeur du courant de charge ou du courant de décharge a lieu pour chaque bloc partiel de charge ou de décharge (10L, 20L, 30L, 40L ; 10E, 20E, 30E, 40E) en fonction de la longueur de l'interruption précédente (12, 22 32), de façon à garantir que, au deuxième instant (t7), le deuxième état de charge (SOC2) soit atteint.

12. Système électrique comprenant un dispositif selon la revendication 11 et un accumulateur d'énergie, dans lequel l'accumulateur d'énergie est un accumulateur lithium-titanate ou un accumulateur d'énergie avec une chimie de batterie comparable.

FIG 1

FIG 2

FIG 3

FIG 4

EP 3 243 254 B1

FIG 5

EP 3 243 254 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010076608 A1